# EUROPEAN PATENT APPLICATION

(11) **EP 4 734 691 A1**
(43) Date of publication of application: **29.04.2026**
(21) Application number: 23942344.5
(22) Date of filing: 21.06.2023
(51) Int. Cl.: H05K 13/00

(54) **COMPONENT MOUNTER AND COMPONENT MOUNTING METHOD**

(71) Applicant: Fuji Corporation, Chiryu-shi, Aichi 472-8686 (JP)
(72) Inventor: KAGOSHIMA, Hiroyuki, Chiryu-shi, Aichi 472-8686 (JP); MIZUNO, Takayuki, Chiryu-shi, Aichi 472-8686 (JP); YAMAZAKI, Tomohiro, Chiryu-shi, Aichi 472-8686 (JP)
(74) Representative: Grünecker Patent- und Rechtsanwälte PartG mbB
(86) International application number: PCT/JP2023/022936
(87) International publication number: WO 2024/261907

(57) **Abstract**

A component mounter includes: a board conveyance device configured to convey a board and position the board at a predetermined work position; a carrier member on which a strip-shaped carrier tape in which components to be mounted on the board are respectively accommodated in multiple cavities arranged in a row and a tray in which the components are respectively accommodated in multiple accommodation portions arranged in a grid pattern are placed, the carrier member being disposed inside the component mounter; and a component transfer device configured to pick up the component from the carrier member and mount the picked-up component on the board positioned at a work position.

## Description

### Technical Field

The present description relates to a component mounter that performs mounting work of mounting a component on a board, and a component mounting method using the component mounter.

### Background Art

A technique for mass-producing board products by performing board work on a board on which a circuit pattern is formed has become widespread. As a representative example of a board work machine that performs board work, there is a component mounter that performs mounting work of mounting a component on a board. In general, the component mounter includes a board conveyance device, a component supply device, and a component transfer device, and performs the mounting work based on a work program created for each type of board. When changing a type of a board (board product) to be produced, it is necessary to perform a changeover of the three devices and to replace the work program. A technical example related to the production of this type of board is disclosed in Patent Literatures 1 to 3.

Patent Literature 1 discloses a production plan determination method in which a production plan for multiple types of board products includes a changeover for at least one of a component feeder, a nozzle, and a mounting head, and which includes a step of, when interrupt production of another board product is performed, searching for, in an initial production plan, insertion candidates where the interrupt production can be inserted, a step of calculating a changeover time required before and after the interrupt production for each insertion candidate, and a step of determining a production plan by inserting the interrupt production into one insertion candidate based on the calculated changeover time. With this, even when the interrupt production is inserted, the influence on the overall production time can be reduced.

In addition, Patent Literature 2 discloses a method of determining a changeover plan, the method including a step of determining an initial setup plan for changeover members such as a component feeder and a suction nozzle provided in a component mounter that produces a board product, and a step of, when interrupt production of another board product is performed, determining an interrupt setup plan for the changeover members based on installation positions of the changeover members before and after the interrupt production and inserting the interrupt setup plan into the initial setup plan. According to this, the number of changeovers can be reduced by taking into account the installation positions of the changeover members in the production before and after the interrupt production, and the time required for the changeover can be shortened.

Further, Patent Literature 3 discloses an assembly device including a pallet on which an assembly target object and assembly components are simultaneously placed, a conveyance device that conveys the pallet and positions the pallet at a work position, and assembling means for attaching the assembly components to predetermined attachment locations on the assembly target object, in which placement positions of the assembly components are on a straight line in a specific direction of the attachment locations. With this, by minimizing a moving mechanism of the assembling means, equipment cost can be reduced and work efficiency can be improved.

### Citation List

### Patent Literature

Patent Literature 1: WO 2013/124959
Patent Literature 2: JP-A-2011-146551
Patent Literature 3: WO 2007/049341

### Summary of the Invention

### Technical Problem

Incidentally, while the component mounter is producing a board (planned production board) based on a production plan, an interrupt request for producing a repair board or a prototype board (interrupt production board) that is not included in the production plan may occur. In this case, it is necessary to perform a changeover of the board conveyance device, the component supply device, the component transfer device, and the work program for adaptation to the interrupt production board, and to perform the changeover again after completion of the production of the interrupt production board in order to resume the production of the planned production board. That is, a large number of man-hours for the changeover are required for a limited number of interrupt production boards. In particular, since the component supply device supplies various types of components using multiple carrier tapes, trays, or the like, a large number of man-hours are often required for the changeover.

Further, in the production of the interrupt production board, a supply form of components may differ from that in normal production, and, in such a case, the installed component supply device cannot be used, so that measures are required. In addition, in mounting work of repairing the repair board, it is difficult to reproduce the setup status during production, and in addition, the work program used during production cannot be used as it is. In addition, the repair board may differ in external shape from that during production. There is a case where the mounting work cannot be performed on the prototype board using the work program. Thus, in the interrupt request for the interrupt production board, a special changeover is required, and a large number of man-hours are necessary for the response. The problem of requiring a large number of man-hours for the changeover is not limited to the above-described interrupt production, and can generally occur when changing the type of board.

To address the above problem, in the technical example of Patent Literature 1, the interrupt production is inserted by selecting an insertion candidate timing at which the changeover time is reduced. However, the interrupt production generally requires early response, and, in the technical example of Patent Literature 1, early response cannot be achieved. In addition, in the technique example of Patent Literature 2, the changeover is performed so that the number of changeovers is reduced by taking into account the installation positions of the changeover members before and after the interrupt production. However, in the technical example of Patent Literature 2, even though the number of changeovers can be reduced, since the work content itself is not changed, so that it cannot be said that the changeover is sufficiently efficient. Further, in the technical example of Patent Literature 3, there is no specific description for improving efficiency of the changeover when changing the assembly target object and the assembly components.

Therefore, an object of the present description is to provide a component mounter and a component mounting method that can make changeover related to component supply more efficient than in a related-art case by changing work contents of the changeover.

### Solution to Problem

The present description discloses a component mounter including: a board conveyance device configured to convey a board and position the board at a predetermined work position; a carrier member on which a strip-shaped carrier tape in which components to be mounted on the board are respectively accommodated in multiple cavities arranged in a row and a tray in which the components are respectively accommodated in multiple accommodation portions arranged in a grid pattern are placed, the carrier member being disposed inside the component mounter; and a component transfer device configured to pick up the component from the carrier member and mount the picked-up component on the board positioned at a work position.

In addition, the present description discloses a component mounting method using a component mounter including a tray feeder, a board conveyance device, and a component transfer device, the component mounting method including: a setup step of disposing, on the tray feeder, a carrier member on which a strip-shaped carrier tape in which components to be mounted on a board are respectively accommodated in multiple cavities arranged in a row and a tray in which the components are respectively accommodated in multiple accommodation portions arranged in a grid pattern are placed; a first work step of, via the component transfer device, mounting, on a first board positioned at a predetermined work position by the board conveyance device, components accommodated in a second tray that accommodates components of a type different from the components accommodated in the tray without using the carrier member; and a second work step of, via the component transfer device, mounting, on a second board positioned at a predetermined work position by the board conveyance device, the components accommodated in the carrier member.

The present description discloses a technical idea in which "the component mounter according to Claim 1" in Claim 5 as originally filed is changed to "the component mounter according to any one of Claims 1 to 4", a technical idea in which "the component mounter according to Claim 10" in Claim 12 as originally filed is changed to "the component mounter according to Claim 10 or 11", a technical idea in which "the component mounter according to Claim 1" in Claim 14 as originally filed is changed to "the component mounter according to any one of Claims 1 to 13", a technical idea in which "the component mounter according to Claim 1" in Claim 15 as originally filed is changed to "the component mounter according to any one of Claims 1 to 14", a technical idea in which "the component mounter according to Claim 15" in Claim 17 as originally filed is changed to "the component mounter according to Claim 15 or 16", a technical idea in which "the component mounter according to Claim 15" in Claim 20 as originally filed is changed to "the component mounter according to any one of Claims 15 to 17", and a technical idea in which "the component mounter according to any one of Claims 1 to 7" in Claim 23 as originally filed is changed to "the component mounter according to any one of Claims 1 to 22".

### Advantageous Effects of Invention

In the component mounter and the component mounting method disclosed in the present description, with respect to the component supply, it is possible to perform changeover work of disposing the carrier member on which the strip-shaped carrier tape and the tray are placed inside the component mounter. With this, it is possible to perform changeover work targeting a carrier member capable of supplying components, instead of the related-art changeover work targeting a reel around which a long carrier tape is wound, a tape feeder that supplies components using the reel, a pallet on which a tray is placed, and the like. Therefore, the changeover can be made more efficient than in a related-art case.

### Brief Description of Drawings

Fig. 1 is a plan view schematically illustrating an overall configuration of a component mounter of a first embodiment.
Fig. 2 is a side view schematically illustrating a detailed configuration of a tray feeder.
Fig. 3 is a plan view illustrating a pallet and a second tray placed thereon.
Fig. 4 is a plan view illustrating a carrier member with a carrier tape and a tray placed thereon.
Fig. 5 is an image diagram illustrating carrier-internal position information and a function of a camera position command section.
Fig. 6 is a diagram illustrating an example of a screen displayed by a display device.
Fig. 7 is a diagram of an operation flow illustrating an operation of the component mounter.
Fig. 8 is a diagram of a sub-operation flow illustrating details of changeover work in step S5 in Fig. 7.
Fig. 9 is a plan view schematically illustrating an overall configuration of a component mounter of a second embodiment.
Fig. 10 is a plan view illustrating a carrier member, a tool station, and a positioning jig used in the second embodiment.
Fig. 11 is an image diagram illustrating carrier-internal position information and a function of a camera position command section in the second embodiment.

### Description of Embodiments

### 1. Overall Configuration of Component Mounter 1 of First Embodiment

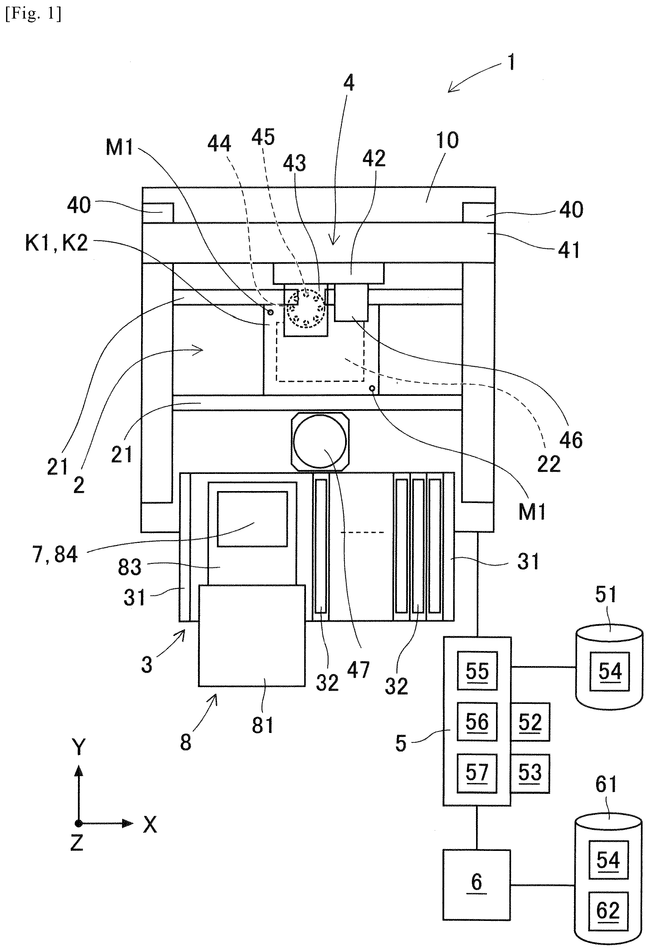

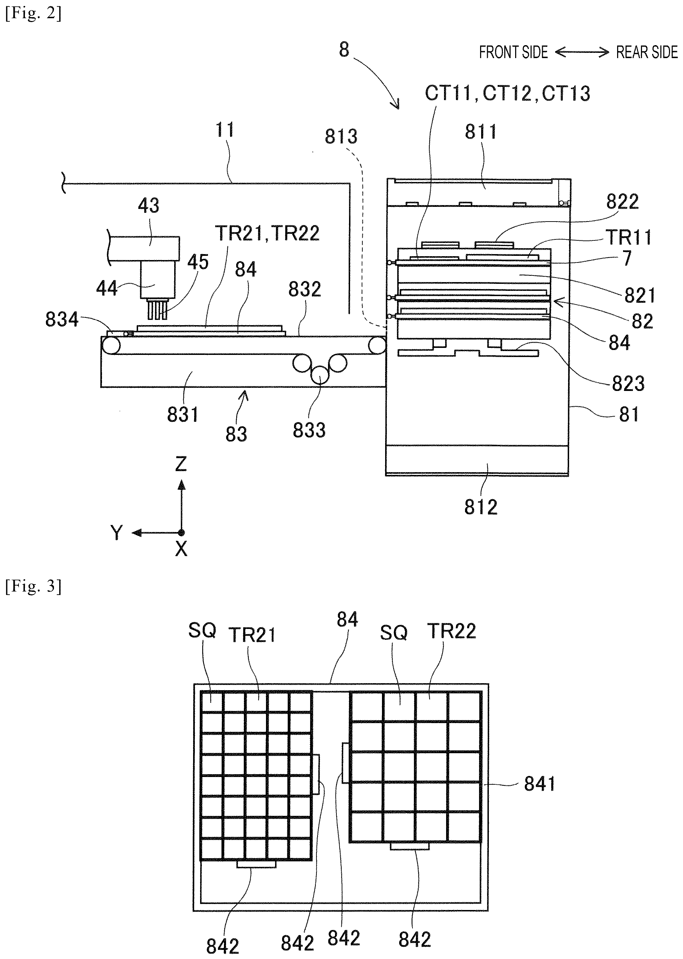

An overall configuration of component mounter 1 of a first embodiment will be described with reference to Fig. 1. A horizontal direction from a left side to a right side on a drawing surface in Fig. 1 is an X-axis direction in which first board K1 and second board K2 are conveyed, a horizontal direction from a drawing surface lower side (front side) to a drawing surface upper side (rear side) is a Y-axis direction, and a vertical direction is a Z-axis direction. The term "first" attached to first board K1 and the term "second" attached to second board K2 are used to clearly indicate that the types of boards are different, and do not mean a specific board. Hereinafter, when there is no need to distinguish between first board K1 and second board K2, first board K1 and second board K2 are simply referred to as a "board". Component mounter 1 is configured by attaching board conveyance device 2, component supply device 3, component transfer device 4, and control device 5, and the like to base 10. Base 10 has a substantially rectangular parallelepiped shape and is firmly formed. Protection cover 11 (see Fig. 2) that is manually openable and closable is provided above base 10. Protection cover 11 ensures the safety of a worker and prevents dust or the like from entering into component mounter 1.

Board conveyance device 2 includes pair of guide rails 21, a pair of conveyor belts (not illustrated), a belt drive section (not illustrated), clamp mechanism 22, and the like. Pair of guide rails 21 extend in the X-axis direction across a slightly rear side of an upper surface of base 10, and are attached to base 10 in parallel with each other. Separation distance between pair of guide rails 21 is adjusted according to a width dimension (Y-axis direction dimension) of the boards (first board K1, second board K2). The minimum width dimension and the maximum width dimension of the conveyable board are determined according to an adjustment range of the separation distance.

The pair of conveyor belts are driven by the belt drive section and rotarily travel along guide rail 21 in a state where two parallel sides of the rectangular board are placed on the pair of conveyor belts. Accordingly, board conveyance device 2 carries the board into component mounter 1 from a carry-in end (left end in Fig. 1) and conveys the board to a predetermined work position near the center of base 10. Clamp mechanism 22 pushes up the board stopped at the work position and clamps and positions the board between guide rail 21 and clamp mechanism 22. After mounting work of component transfer device 4 is completed, clamp mechanism 22 releases the board, and the conveyor belt conveys the board to a carry-out end (right end in Fig. 1) and carries out the board to the outside of component mounter 1.

Component supply device 3 is disposed on one side (lower side in Fig. 1) of base 10 in the Y-axis direction. Component supply device 3 includes mounting base 31, multiple tape feeders 32, tray feeder 8, and the like. Mounting base 31 is a substantially rectangular member in a plan view. As illustrated in Fig. 1, mounting base 31 has multiple slots arranged in the X-axis direction while extending in the Y-axis direction in parallel with each other, in an area of approximately half on the downstream side in a conveyance direction (X-axis direction). Tape feeders 32 are detachably attached to and arranged in the multiple slots, respectively. Each of tape feeders 32 feeds a second carrier tape wound around a reel to a component supply position and supplies a component to be mounted on the board. The term "second" attached to the second carrier tape is used to clearly indicate that a type of a component to be supplied is different from those of carrier tapes (CT11, CT12, and CT13) described below, and does not mean a specific carrier tape.

On mounting base 31, tray feeder 8 is attached to approximately a half area on the upstream side in the conveyance direction. Tray feeder 8 supplies a component to be mounted on the board using a second tray. The term "second" attached to the second tray is used to clearly indicate that a type of a component to be supplied is different from that of tray TR11 described below, and does not mean a specific tray. Tray feeder 8 may be either a fixed type that is fixed to mounting base 31 or a detachable type that is detachable from mounting base 31. Further, detachable type tray feeder 8 may be configured in a shape of a cart. A detailed configuration of tray feeder 8 will be described below. Component supply devices 3 may be disposed on both sides (lower side and upper side in Fig. 1) in the Y-axis direction. Further, component supply device 3 may be configured as a cart in its entirety that is detachable from base 10.

Component transfer device 4 includes pair of guide rails 40, Y-axis moving body 41, X-axis moving body 42, mounting head 43, nozzle tool 44, suction nozzle 45, mark camera 46, part camera 47, and the like. Pair of guide rails 40 are disposed at both edges separated from each other in the X-axis direction of base 10, and extend in the Y-axis direction in parallel with each other. Y-axis moving body 41 is formed of a member that is long in the X-axis direction, and is mounted on pair of guide rails 40. Y-axis moving body 41 is driven by a Y-direction drive mechanism (not illustrated) to move in the Y-axis direction. X-axis moving body 42 is mounted on Y-axis moving body 41 and is driven by an X-direction drive mechanism (not illustrated) to move in the X-axis direction.

Mounting head 43 is provided on a front surface of X-axis moving body 42 and is disposed above board conveyance device 2 and component supply device 3. Mounting head 43 moves in two horizontal directions together with X-axis moving body 42. Nozzle tool 44 having a rotationally symmetric shape is rotatably provided on the lower side of mounting head 43. Nozzle tool 44 is driven by an R-axis drive mechanism (not illustrated) to rotate about a vertical central axis. Nozzle tool 44 holds multiple (eight in the example of Fig. 1) suction nozzles 45 exchangeably at positions equidistant from the vertical central axis.

Suction nozzle 45 is driven by a lifting and lowering drive mechanism (not illustrated) to be lifted and lowered, and is driven by a Q-axis drive mechanism (not illustrated) to rotate about a vertical axis. Further, suction nozzle 45 is selectively supplied with negative pressure air and positive pressure air from an air supply mechanism (not illustrated). Accordingly, suction nozzle 45 performs mounting work of picking up a component from the component supply positions of tape feeder 32 and tray feeder 8 and mounting the component on the positioned board. Suction nozzle 45 is a form of a first component mounting tool that picks up a component from tape feeder 32 or the second tray. Mounting head 43 may hold one suction nozzle 45 without nozzle tool 44, or may hold multiple suction nozzles 45 arranged in a row or in a grid pattern. In addition, mounting head 43 may hold a first component mounting tool other than suction nozzle 45, such as a clamping chuck for clamping a component.

Mark camera 46 is provided facing downward on X-axis moving body 42 alongside mounting head 43, and moves integrally with X-axis moving body 42 and mounting head 43. Mark camera 46 has a square or rectangular image-capturing range, and the image-capturing range is significantly narrower than the size of the board, while it is possible to acquire fine image data by image-capturing. The board to be a subject of mark camera 46 has board position marks M1 attached in the vicinity of two corners positioned on a diagonal line. Mark camera 46 captures images of two board position marks M1 twice separately to acquire image data. An image processing section attached to mark camera 46 performs image processing on the image data to detect accurate positions of two board position marks M1, thereby detecting an accurate work position of the board and a rotation angle of the board in a horizontal plane. The detection result is reflected in the mounting work.

Part camera 47 is provided facing upward on base 10 between board conveyance device 2 and component supply device 3. Part camera 47 captures an image of the component held by suction nozzle 45 from below and recognizes the component while mounting head 43 moves from component supply device 3 to first board K1. As a result, it is determined whether the type of the component is correct or incorrect, and the position and orientation of the component with respect to suction nozzle 45 are detected and reflected in the mounting work. Mark camera 46 and part camera 47 may be, for example, a digital imaging device including an imaging element such as a charge-coupled device (CCD) or a complementary metal-oxide semiconductor (CMOS).

Control device 5 is attached to base 10, and the position of control device 5 is not limited. Control device 5 includes a computer device having CPU and operated with software. Control device 5 may be configured such that multiple CPUs are distributed and disposed inside the device and are connected in communication with each other. Control device 5 includes storage device 51 that stores various types of information. In addition, control device 5 includes input device 52 such as a keyboard or a touch panel that receives a command, a selection operation, or the like from the worker or the like. Further, control device 5 includes display device 53 such as a liquid crystal display that displays various types of information to the worker or the like.

Control device 5 receives work program 54 transferred from higher-level production management device 6 and stores work program 54 in storage device 51. Work program 54 is used for the mounting work and is created for each type of board (board product). Work program 54 includes design data for each type of board, and design data summarizing types, shapes, and the number of components to be mounted on the board. In addition, work program 54 includes coordinate data of a component supply position (component pickup position) and coordinate data of a component mounting position on the board. Further, work program 54 includes data related to the types and arrangement positions of tape feeder 32, tray feeder 8, and suction nozzle 45, as well as detailed procedure data for the mounting work. Based on work program 54, control device 5 causes board conveyance device 2, component supply device 3, and component transfer device 4 to proceed with the mounting work.

### 2. Detailed Configuration of Tray Feeder 8

Tray feeder 8 is a device that supplies components by disposing, inside component mounter 1, pallet 84 on which the second tray is placed. As illustrated in Fig. 2, tray feeder 8 includes housing 81, tray stocker 82, tray conveyance section 83, and the like. Housing 81 is a generally rectangular parallelepiped housing having a vertically elongated shape. Tray carry-in section 811 is provided at an upper portion of housing 81, and tray discharge section 812 is provided at a lower portion of housing 81. Tray conveyance port 813 is open on the front side of housing 81 at a substantially intermediate height.

Tray stocker 82 is disposed inside housing 81. Tray stocker 82 is a substantially box-shaped member having five storage shelves 821 arranged vertically. Each of storage shelves 821 stores pallet 84 such that pallet 84 can be pulled out forward. In other words, tray stocker 82 stores multiple pallets 84 in a pull-out manner while arranging pallets 84 in a vertical direction. Pallet 84 is a member used to supply components. In the example of Fig. 2, tray stocker 82 stores pallets 84 in third and fourth storage shelves 821 from the top.

Tray stocker 82 is driven by a lifting and lowering mechanism (not illustrated) to be lifted and lowered inside housing 81. A ball screw feed mechanism or a linear motor mechanism can be used as the lifting and lowering mechanism. Carry-in holding section 822 is provided on an upper surface of tray stocker 82, and discharge holding section 823 is provided on a lower surface of tray stocker 82. Carry-in holding section 822 receives and temporarily holds pallet 84 carried into tray carry-in section 811. Discharge holding section 823 temporarily holds pallet 84 in which a component-out has occurred, and discharges pallet 84 to tray discharge section 812.

Tray conveyance section 83 is disposed on the front side of housing 81. Tray conveyance section 83 includes conveyance section body 831, pair of conveyance conveyors 832, drive sprocket 833, multiple support sprockets whose reference numerals are omitted, pallet connector 834, and the like. Conveyance section body 831 is disposed such that a rear portion faces tray conveyance port 813 and a front portion is located within a movement range of mounting head 43. Pair of conveyance conveyors 832 have an endless annular shape, and are disposed spaced apart from each other in a width direction of conveyance section body 831. Pair of conveyance conveyors 832 are rotatably supported by multiple support sprockets and drive sprocket 833 axially supported by conveyance section body 831, and extend in a front-rear direction. Pair of conveyance conveyors 832 are driven by drive sprocket 833 and a motor (not illustrated) to rotate. Pallet connector 834 is provided midway along conveyance conveyor 832. Pallet connector 834 detachably grips pallet 84.

Tray conveyance section 83 grips pallet 84 with pallet connector 834, places pallet 84 on conveyance conveyor 832, and conveys pallet 84 by the rotation of conveyance conveyor 832. Accordingly, tray conveyance section 83 performs an operation of pulling out pallet 84 from tray stocker 82 to an upper surface of conveyance section body 831 via tray conveyance port 813, and an operation of storing pallet 84 in a reverse direction. In the example of Fig. 2, tray conveyance section 83 pulls out pallet 84 stored in the fifth shelf from the top of tray stocker 82 to a component supply position set on the upper surface of conveyance section body 831.

As illustrated in Fig. 3, pallet 84 is formed of a substantially rectangular plate-shaped member. On pallet 84, a second tray is placed, and, in the example of Fig. 3, two second trays (TR21 and TR22) are placed. Pallet 84 positions the second trays (TR21 and TR22) using frame portion 841 disposed on four sides of a rectangle and protruding upward, and movable-type set pieces 842. Specifically, each of the two second trays (TR21 and TR22) is positioned with their four sides in contact with two adjacent sides of frame portion 841 and two set pieces 842. Pallet 84 may position the second tray using only set piece 842 without frame portion 841. In addition, set piece 842 may be formed in an L-shape and contact two adjacent sides of the rectangular second tray.

Next, a carry-in operation, a component supply operation, and a carry-out operation of tray feeder 8 will be described. Prior to the carry-in operation, the worker carries pallet 84 on which the second tray is placed into tray carry-in section 811. Then, tray feeder 8 starts the carry-in operation, tray stocker 82 is raised, and carry-in holding section 822 receives and holds pallet 84. Next, tray stocker 82 is lowered so that pallet 84 faces tray conveyance port 813, and tray conveyance section 83 pulls out pallet 84. Next, tray stocker 82 is raised so that one of storage shelves 821 faces tray conveyance port 813, and tray conveyance section 83 stores pallet 84 in storage shelf 821.

In the component supply operation, tray stocker 82 is raised or lowered so that one of pallets 84 faces tray conveyance port 813, and tray conveyance section 83 pulls out pallet 84 from storage shelf 821 to the component supply position. After suction nozzles 45 pick up the component from the second trays (TR21 and TR22) on pallet 84, tray conveyance section 83 stores pallet 84 in storage shelf 821 again. Next, another pallet 84 is designated in order to change the type of the component to be supplied, tray stocker 82 is raised or lowered, and designated pallet 84 is pulled out and stored by tray conveyance section 83. Further, designation of another pallet 84, raising or lowering of tray stocker 82, and pulling-out and storage by tray conveyance section 83 are repeated.

When a component-out occurs in pallet 84 at the component supply position, in other words, when all accommodation portions SQ of one or both of the two second trays (TR21 and TR22) are empty, the carry-out operation is performed. In the carry-out operation, first, tray stocker 82 is raised, and discharge holding section 823 faces tray conveyance port 813. Next, tray conveyance section 83 moves pallet 84 to discharge holding section 823, and discharge holding section 823 receives and holds pallet 84. Next, tray stocker 82 is lowered, and discharge holding section 823 discharges pallet 84 to tray discharge section 812. Since a space is generated in storage shelf 821 by the carry-out operation, tray feeder 8 can perform a carry-in operation of another pallet 84 as necessary.

The number of tray stockers 82 disposed inside housing 81 may be plural, and the number of stages of storage shelves 821 is not limited to five. In addition, tray feeder 8 may have a replacement door on a rear surface of housing 81, and may be configured such that the worker directly loads and unloads pallet 84 into and from storage shelf 821 through the replacement door. Further, tray feeder 8 may be configured such that tray stocker 82 is exchanged as a unit, rather than pallet 84 being exchanged as a unit. In addition, tray feeder 8 may be configured such that pallet 84 is omitted, tray stocker 82 stores the second tray in storage shelf 821, and tray conveyance section 83 pulls out the second tray to the component supply position. In addition, tray feeder 8 may be configured such that housing 81 is omitted, tray stocker 82 is held at a predetermined height position, and tray conveyance section 83 is lifted and lowered to select designated pallet 84.

### 3. Problems in Component Mounter having Related-Art Configuration

Production management device 6 stores and manages, in storage device 61, production plans 62 for multiple types of boards and work program 54 for each type of board. Production plan 62 includes at least a production order and a production quantity of multiple types of boards. When the production time of first board K1 in production plan 62 arrives, production management device 6 transfers work program 54 for first board K1 to component mounter 1 and another board work machine, and commands production of first board K1. While component mounter 1 produces first board K1 in accordance with the command, an interrupt request for producing second board K2 that is not included in production plan 62 may occur.

First board K1 can also be referred to as a planned production board that is produced based on production plan 62. Second board K2 is different in type from first board K1, and can be referred to as an interrupt production board that is produced by interrupting production plan 62. Second board K2 is a prototype board, a repair board, or the like, and requires early response, and, in many cases, the production quantity is limited.

When the interrupt request occurs, in a component mounter having a related-art configuration, it is necessary to perform a changeover of board conveyance device 2, component supply device 3, component transfer device 4, and work program 54 for adaptation to second board K2, and to perform the changeover again after completion of the production of second board K2 in order to resume the production of first board K1. That is, a large number of man-hours for the changeover are required for the limited number of second boards K2. For example, the components to be mounted on second board K2 may be different in type from the components to be supplied by tape feeders 32 arranged on mounting base 31, which requires the changeover of tape feeders 32 and requires man-hours. In addition, in many cases, a large number of man-hours are required for the changeover of multiple tape feeders 32. In tray feeder 8 as well, in many cases, a large number of man-hours are required for the changeover of multiple pallets 84.

Further, the components to be mounted on second board K2 may have a supply form different from that in normal production, and, in such a case, installed component supply device 3 may be unusable. For example, when components are supplied in a form of a cut strip-shaped carrier tape, general tape feeder 32 cannot be used. Therefore, a special device is required in place of installed component supply device 3. In addition, it is necessary to correct coordinate value data of the component supply position in work program 54.

In addition, in the mounting work of repairing the repair board, it is difficult to reproduce the setup status during production, and in addition, work program 54 used during production cannot be used as it is. For example, since some of the components involved in the failure need only to be remounted on the repair board, it is necessary to specify necessity of remounting for each type of component in work program 54. Further, the repair board may be different in size and shape from those during production. For example, the outer periphery of the repair board may be cut in accordance with a final use form, requiring correction of coordinate value data of the component mounting position in work program 54.

There is a case where the mounting work cannot be performed on the prototype board by using work program 54. For example, there may be a case where work program 54 is not created or a case where the compatibility is not sufficiently verified. In this case, the worker manually proceeds with the mounting work while checking the component at the component supply position, the component mounting position on second board K2, or the like. In addition, work program 54 created on the assumption of mass production needs to be partially corrected for trial production.

As described above, in order to perform the changeover in response to the interrupt request for producing second board K2 that is not included in production plan 62, worker man-hours are required. Further, in order to resume the production of first board K1 by returning to the original setup state after completion of the production of second board K2, changeover man-hours are required again. That is, a large number of man-hours are required for two changeovers, and the changeover time becomes long. In particular, since component supply device 3 supplies various types of components using multiple carrier tapes and trays, a large number of man-hours are often required for the changeover. As a countermeasure to this, in the first embodiment, carrier member 7 is used in the production of second board K2. In addition, mode switching section 55 switches whether to use carrier member 7.

### 4. Carrier Member 7

As with pallet 84, carrier member 7 is a member used to supply components. Carrier member 7 is formed of a rectangular plate-shaped member having substantially the same shape and size as pallet 84. Carrier member 7 is handled in tray feeder 8 in the same manner as pallet 84. That is, carrier member 7 is stored in storage shelf 821 of tray stocker 82, and is stored in first storage shelf 821 from the top in the example of Fig. 2. Further, carrier member 7 is pulled out to the component supply position by tray conveyance section 83. Therefore, tray feeder 8 can supply components by selectively and automatically exchangeably disposing pallet 84 on which the second tray is placed and carrier member 7 inside component mounter 1. In addition, component transfer device 4 can pick up the component from carrier member 7 and mount the picked-up component on a board positioned at a work position.

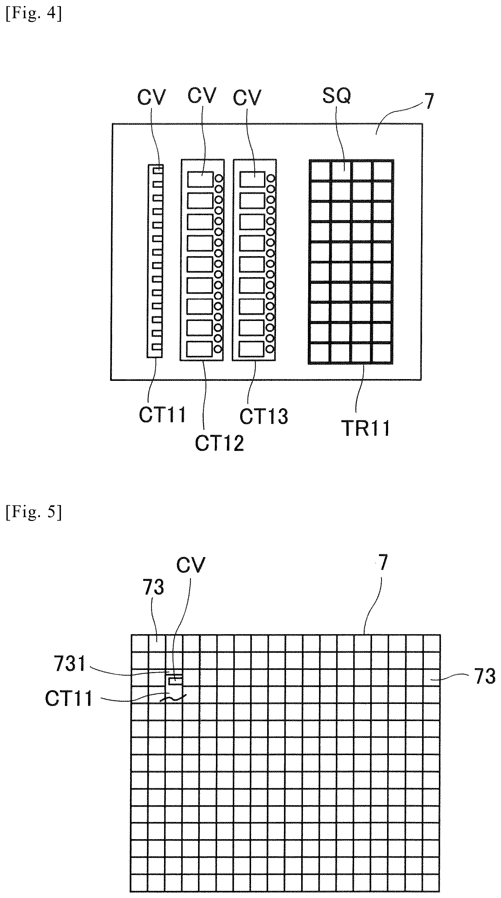

A strip-shaped carrier tape and a tray are placed on carrier member 7. In the example of Fig. 4, one carrier tape CT11 having a relatively small tape width dimension, two carrier tapes (CT12 and CT13) having a relatively large tape width dimension, and one tray TR11 are placed on carrier member 7. In the following description, the carrier tapes (CT11, CT12, and CT13) and tray TR11 placed on carrier member 7 may be referred to as component containers. In order to position the component container, the worker can attach the component container using, for example, a double-sided tape.

The carrier tapes (CT11, CT12, and CT13) accommodate components in multiple cavities CV arranged in a row. Each of the carrier tapes (CT11, CT12, and CT13) is obtained by cutting a part of a long tape and has a strip shape (elongated rectangle). Carrier tape CT11 has the same tape width dimension as the second carrier tape used by tape feeder 32 arranged on mounting base 31, but cannot be used in tape feeder 32 because carrier tape CT11 is cut. Carrier tape CT12 and carrier tape CT13 has a relatively large tape width dimension, and is used in another type of tape feeder larger than tape feeder 32. The types of components supplied by the carrier tapes (CT11, CT12, and CT13) are different from the types of components supplied by the second carrier tape of tape feeder 32 arranged on mounting base 31. Cover tapes covering cavities CV of the carrier tapes (CT11, CT12, and CT13) are removed by the worker at an appropriate time.

Tray TR11 accommodates components in multiple accommodation portions SQ arranged in a grid pattern. The types of components supplied by tray TR11 are different from the types of components supplied by the second trays (TR21 and TR22) on pallet 84 stored in tray stocker 82. When accommodation portions SQ of tray TR11 are covered with a protective sheet, the protective sheet is removed by the worker at an appropriate time. The components supplied by carrier member 7, that is, the components supplied by the carrier tapes (CT11, CT12, and CT13) and tray TR11 are mounted on second board K2, but are not mounted on first board K1.

The worker uses input device 52 to input in advance known shape information of the component containers (carrier tapes (CT11, CT12, and CT13), and tray TR11) and information on the types of the accommodated components, and stores the information in storage device 51. The shape information includes at least the quantity, disposition, and accommodation pitch distance of the accommodated components. The shape information is referenced when detecting a position of a specific component, when obtaining a position of another component, or the like. The information on the type of the component is referenced in the mounting work. When second board K2 is a prototype board and there is no use record of the component to be mounted, the worker newly registers, in storage device 61, component data summarizing the shape, specification, and the like of the component.

An upper surface of carrier member 7 is divided into multiple elements 73 arranged in a grid pattern. In the example illustrated in Fig. 5, there are 270 elements 73 in total, in which 18 elements 73 are arranged in a left-right direction in the drawing and 15 elements 73 are arranged in an up-down direction in the drawing. Elements 73 may be virtual images, or may be represented by actual grid lines drawn on the upper surface of carrier member 7. In addition, elements 73 may be designated by a combination of row and column numbers being assigned to two orthogonal sides of carrier member 7. The size of each element 73 is not particularly limited. That is, each element 73 may have the same shape and the same size as the image-capturing range of mark camera 46, may be smaller than the image-capturing range, or may be larger than the image-capturing range.

An approximate position of the component container is indicated using carrier-internal position information represented by any element 73. The worker uses input device 52 to input carrier-internal position information of each of the positioned component containers. In the example illustrated in Fig. 5, an approximate position of carrier tape CT11 is indicated by carrier-internal position information representing element 731 in the third row from the top and the third column from the left, which represents a position of cavity CV (or component) at one end (upper end in Fig. 5) which is a specific position.

### 5. Functions of Three Functional Sections of Control Device 5

As illustrated in Fig. 1, control device 5 includes three functional sections configured using software, that is, mode switching section 55, camera position command section 56, and display control section 57. Mode switching section 55 switches between a first work mode and a second work mode. In the first embodiment, mode switching section 55 sets the first work mode in a normal state in which an interrupt request for producing second board K2 is not generated, and performs control to continue production of first board K1. Further, mode switching section 55 switches to the second work mode in response to an interrupt request from production management device 6 or an interrupt request from input device 52 of the worker, and performs control to interrupt the production of first board K1 and produce second board K2. Further, mode switching section 55 switches to the first work mode after the production of second board K2 is completed, and performs control to resume the production of first board K1.

In the first work mode, carrier member 7 is not used. In other words, tray stocker 82 does not store carrier member 7, or, even when tray stocker 82 stores carrier member 7, tray conveyance section 83 does not pull out carrier member 7. Board conveyance device 2 conveys first board K1 and positions first board K1 at the work position. Component transfer device 4 performs mounting work of picking up a component from at least one of tape feeder 32 and the second trays (TR21 and TR22) on pallet 84 and mounting the picked-up component on positioned first board K1. Naturally, component transfer device 4 does not pick up a component from a component container on carrier member 7 that has not been set up.

In the second work mode, carrier member 7 is set up as illustrated in Fig. 4 and stored in tray stocker 82. Board conveyance device 2 conveys second board K2 and positions second board K2 at the work position. Component transfer device 4 performs mounting work of picking up a component from the component container on carrier member 7 pulled out to the component supply position and mounting the picked-up component on second board K2. Component transfer device 4 may also perform mounting work of picking up a component from at least one of tape feeder 32 and the second trays (TR21 and TR22) and mounting the component on second board K2.

In the second work mode, the mounting work cannot be performed only with the approximate position information of the component container indicated by the carrier-internal position information, and accurate position information of the component container is required. Therefore, control device 5 acquires the accurate position of the component container using mark camera 46 prior to the mounting work. Mark camera 46 captures an image of the component container on carrier member 7 and detects the position of the component container.

Specifically, mark camera 46 refers to the shape information of the component container and captures an image of a specific position of the component container or a specific component accommodated at the specific position. An image processing section of mark camera 46 detects an accurate position of at least one component by performing image processing on the acquired image data. Further, mark camera 46 can obtain accurate positions of all components in the component container by referring to the shape information of the component container. Examples of the specific position include cavity CV at one end of the carrier tapes (CT11, CT12, and CT13) and accommodation portion SQ at any corner of tray TR11. As described above, accurately obtaining the component position enables the mounting work.

Camera position command section 56 issues a command for a position of mark camera 46 when capturing an image of the component container (or component) by using the carrier-internal position information described above. When each element 73 is set to have the same shape and the same size as the image-capturing range of mark camera 46, mark camera 46 can acquire image data of the entire region of commanded element 73 in a single image-capturing operation.

When each element 73 is set to be smaller than the image-capturing range of mark camera 46, mark camera 46 can capture an image of at least a part of multiple surrounding elements 73 in addition to commanded element 73. Further, nine elements 73 arranged in three rows and three columns may be set to coincide with the image-capturing range of mark camera 46. According to this, mark camera 46 can collectively capture an image of nine elements 73 with commanded element 73 positioned in the center.

On the other hand, when each element 73 is set to be larger than the image-capturing range of mark camera 46, mark camera 46 cannot acquire the image data of the entire region of element 73 in a single image-capturing operation. In this aspect, camera position command section 56 issues a command for mark camera 46 to capture images at multiple positions in element 73. According to this, mark camera 46 can combine pieces of image data acquired by capturing images at multiple positions to generate image data covering the entire region of commanded element 73.

Therefore, a specific position of the component container or a specific component is reliably reflected in the acquired image data, and an accurate position can be detected by image processing. That is, mark camera 46 can detect the accurate position of the component container without repeating image-capturing by trial and error. When mark camera 46 cannot detect the accurate position of the component container, camera position command section 56 issues a command to set element 73 around first commanded element 73 as the next image-capturing target, and causes mark camera 46 to perform image-capturing again. Therefore, mark camera 46 can detect the accurate position of the component container by capturing images a limited number of times.

Note that second board K2 is a repair board and may be different in size and shape from those during production. In this case, two board position marks M1 of second board K2 positioned at the work position are displaced from the positions described in work program 54 used during production, and their approximate positions are unknown. Therefore, control device 5 acquires the accurate work position of second board K2 using mark camera 46 prior to the mounting work. In this case, an upper surface of second board K2 is divided into multiple elements 73 arranged in a grid pattern, as with the upper surface of carrier member 7. The worker inputs carrier-internal position information in which the approximate position of board position mark M1 of second board K2 is represented by any of elements 73. Accordingly, camera position command section 56 can issue a command for a position of mark camera 46 when capturing an image of board position mark M1 by using the carrier-internal position information. Mark camera 46 can detect the accurate position of board position mark M1 without repeating image-capturing by trial and error, and can detect the accurate work position of second board K2 and the rotation angle of second board K2 in the horizontal plane.

Further, there is a case where second board K2 is a repair board, which is a small board obtained by dividing a large board during production, and does not have board position mark M1 attached. In this case, the accurate position of second board K2 positioned at the work position and the component mounting position on second board K2 are unknown. Therefore, as described above, the upper surface of second board K2 is divided into multiple elements 73, and the worker inputs carrier-internal position information in which an approximate component mounting position of second board K2 is represented by any of elements 73. Accordingly, camera position command section 56 issues a command for a position of mark camera 46 when capturing the component mounting position by using the carrier-internal position information. Mark camera 46 can detect the accurate component mounting position without repeating image-capturing by trial and error.

Display control section 57 edits and controls the display content of display device 53, improves the visibility when the worker visually checks the image data, and supports intuitive understanding. Under the control of display control section 57, display device 53 displays image-capturing position information indicating the position or the image-capturing range of mark camera 46 during image-capturing, and the image data on one screen. The image-capturing position information of mark camera 46 is represented by numerical value information such as coordinate values inside control device 5. However, this numerical value information is not suitable for the worker's intuitive understanding. Therefore, display device 53 superimposes and displays, in a graphical form, the image-capturing position information on the overall image of any one or more of carrier member 7 and the component containers (carrier tapes (CT11, CT12, and CT13), and tray TR11), the overall image being acquired from the outside of component mounter 1.

As the overall image of carrier member 7, for example, image data separately acquired by an optical camera having a wide image-capturing range can be used. In addition, as the overall image of the component container, image data acquired by the optical camera or shape information of the component container that can be acquired from a brochure, specifications, or the like can be used.

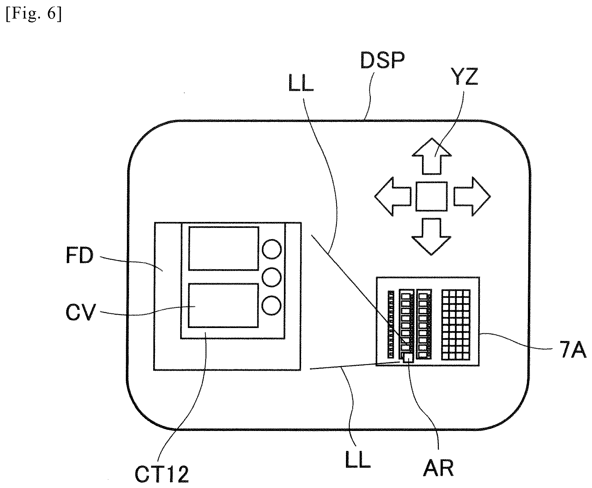

On screen DSP of display device 53 illustrated in Fig. 6, image-capturing range AR of mark camera 46 during image-capturing is superimposed and displayed on overall image 7A of carrier member 7 in a graphical form. Further, image data FD obtained by capturing an image of image-capturing range AR is enlarged and displayed. Image data FD is associated with image-capturing range AR in overall image 7A using enlargement assist line LL. Image data FD is obtained by capturing an image in the vicinity of an end portion of carrier tape CT12. The worker can visually recognize image data FD and check an actual position and accommodation posture of a component accommodated in cavity CV of carrier tape CT12.

In addition, the worker can click arrows YZ in four directions displayed on screen DSP to input a command to move mark camera 46. Control device 5 performs control to move mark camera 46 together with X-axis moving body 42 based on the command given by the click operation. Mark camera 46 automatically captures an image after the movement is completed. Display device 53 automatically updates and redisplays the position of image-capturing range AR and image data FD. Note that image-capturing range AR may be superimposed and displayed on the overall image of carrier tape CT12 in a graphical form, instead of overall image 7A of carrier member 7.

The image-capturing position information is not limited to image-capturing range AR, and may be a symbol or the like indicating the position of mark camera 46 during image-capturing in a pinpoint manner. Display device 53 that displays the image-capturing position information (image-capturing range AR) and image data FD on one screen DSP can also be used to check other portions. Checking the other portions includes checking the position of second board K2, checking the state of the component mounting position on second board K2, checking the actual position and mounting state of the component mounted on second board K2, and the like.

As described above, mark camera 46 captures images of the component containers (carrier tapes (CT11, CT12, and CT13), and tray TR11) placed on carrier member 7 as subjects. In addition, mark camera 46 captures an image of a predetermined component mounting position or a mounted component on second board K2 as a subject. The image processing section of mark camera 46 performs image processing on the acquired image data to detect the position of the component container and check the component mounting position on second board K2 and the state of the mounted component. Display device 53 performs the display illustrated in Fig. 6. By checking the display content, the worker can efficiently proceed with the setup of work program 54 for second board K2 described below and the manual mounting work. Display device 53 may enlarge and display image data captured and acquired by part camera 47 so that the worker can check the state in which suction nozzle 45 picks up the component.

After switching to the second work mode as described above, mode switching section 55 selects and sets one of an automatic mounting mode and a manual mounting mode in response to a command from the worker. Further, mode switching section 55 sets a setup mode prior to the setting of the automatic mounting mode. In the setup mode, the worker refers to the display of display device 53 and sets up work program 54 for second board K2 by which component transfer device 4 automatically performs the mounting work. The term "setup" means creating or editing work program 54 so as to conform to a current state of the component container on carrier member 7, storing work program 54 in storage device 51, and thereby preparing a state in which control device 5 can execute work program 54.

When second board K2 is a prototype board, the worker needs to edit or correct at least coordinate data of the component supply position in work program 54. When second board K2 is a repair board, the worker needs to specify whether remounting is required for each type of component described in work program 54, in addition to editing the coordinate data of the component supply position. In the next automatic mounting mode, component mounter 1 automatically performs the mounting work on second board K2 based on work program 54.

In the manual mounting mode, the worker manually performs the mounting work on second board K2 while referring to the display of display device 53. At this time, the worker can proceed with the mounting work by manually controlling component transfer device 4 while referring to image data FD displayed on screen DSP and checking the position and state of the component to be picked up next, the state of the component mounting position on second board K2, the actual position and mounting state of the mounted component, or the like. In the manual mounting mode, work program 54 that is not essential may be created or edited. According to this, the worker can efficiently proceed with the manual mounting work by referring to the description of work program 54 together with the enlarged display of image data FD.

### 6. Operation of Component Mounter 1

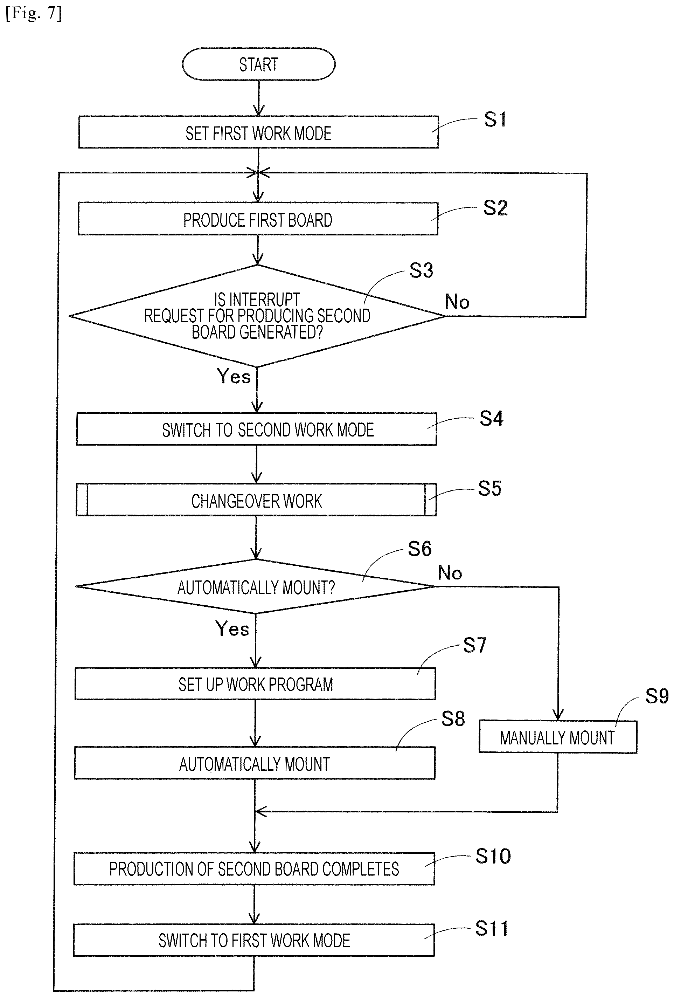

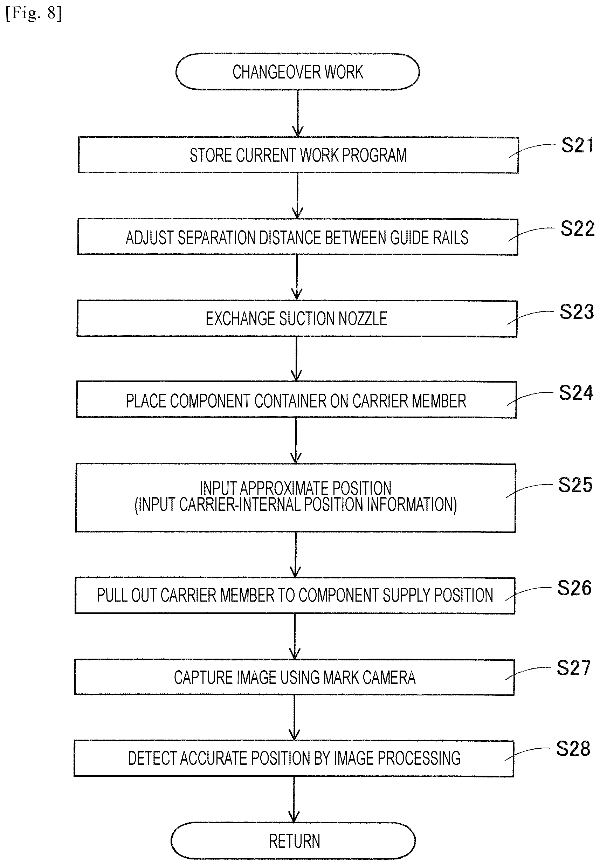

Next, an operation of component mounter 1 will be described with reference to Figs. 7 and 8. An operation flow illustrated in Fig. 7 is mainly carried out under control of control device 5, and partly carried out by the worker. As a prerequisite, it is assumed that first board K1 is planned first in the production order of production plan 62, and the production of second board K2 is not planned at the present time. The following description includes parts related to a component mounting method of the embodiment.

In step S1 of Fig. 7, mode switching section 55 of control device 5 sets the first work mode to produce first board K1 in accordance with production plan 62. The worker performs setup work for adaptation to first board K1. In the setup work, adjustment of the separation distance between pair of guide rails 21 of board conveyance device 2, exchange of tape feeder 32 or the second carrier tape of component supply device 3, exchange of pallet 84 of tray feeder 8, and exchange of suction nozzle 45 of component transfer device 4 are performed as necessary. Further, work program 54 for first board K1 is transferred and stored.

In next step S2, control device 5 starts production (mounting work) of first board K1. The production of first board K1 is continued until an interrupt request for producing second board K2 occurs in step S3. Step S2 is a step of mounting the components accommodated in the second trays (TR21 and TR22) or mounting the components accommodated in the second carrier tape attached to tape feeder 32 on first board K1 without using carrier member 7, and corresponds to a first work step of the component mounting method of the embodiment. In step S4 after the interrupt request is generated, mode switching section 55 switches to the second work mode. In next step S5, the worker performs changeover work adapted to the production of second board K2. Details of the changeover work are illustrated in a sub-operation flow of Fig. 8.

In step S21 of Fig. 8, the worker stores work program 54 currently prepared for second board K2 in storage device 51. In next step S22, the worker adjusts the separation distance between pair of guide rails 21 of board conveyance device 2 when first board K1 and second board K2 have different width dimensions.

In next step S23, the worker exchanges suction nozzle 45 as necessary. In next step S24, the worker places and positions the component containers (carrier tapes (CT11, CT12, and CT13), and tray TR11) on carrier member 7. Further, the worker carries carrier member 7 into tray carry-in section 811 of tray feeder 8. Step S24 is a step of setting up carrier member 7 and disposing carrier member 7 on tray feeder 8, and corresponds to a setup step of the component mounting method of the embodiment. Tray feeder 8 stores carrier member 7 in empty storage shelf 821 of tray stocker 82. When there is no empty storage shelf 821, tray feeder 8 temporarily retracts pallet 84 that is not used for the production of second board K2 to tray discharge section 812, thereby securing empty storage shelf 821 and storing carrier member 7. Here, the worker does not need to perform the changeover of multiple tape feeders 32 and pallets 84 that require a large number of man-hours.

In next step S25, the worker uses input device 52 to input carrier-internal position information indicating an approximate position of the component container. In next step S26, tray feeder 8 pulls out carrier member 7 to the component supply position. In next step S27, camera position command section 56 uses the carrier-internal position information input in step S25 to issue a command for a position of mark camera 46 when capturing an image of the component container. Mark camera 46 captures an image of the component container in accordance with the command. In next step S28, the image processing section of mark camera 46 performs image processing on the acquired image data to detect the accurate position of the component container. Steps S27 and S28 are repeatedly executed according to the number of component containers. Thereafter, control device 5 ends the sub-operation flow and returns the execution control of the operation flow to step S6 in Fig. 7.

In step S6, mode switching section 55 uses display device 53 to inquire of the worker whether to perform automatic mounting. The worker uses input device 52 to issue a command for either automatic mounting or manual mounting. In step S7 when the automatic mounting command is issued, mode switching section 55 sets the setup mode. The worker edits and sets up the accurate position of the component container detected in step S28 with work program 54 prepared in step S21 as a target. In next step S8, mode switching section 55 sets the automatic mounting mode. Accordingly, component mounter 1 automatically performs the mounting work based on work program 54.

Further, in step S9 when the manual mounting command is issued, mode switching section 55 sets the manual mounting mode. Board conveyance device 2 conveys second board K2 on which cream solder has been printed or applied to the component mounting position by a solder printer or the like on the upstream side, and positions second board K2 at the work position. The worker performs the mounting work by manually controlling component transfer device 4 while referring to the display of display device 53. Since this manual mounting requires a longer time than the automatic mounting, which may cause the cream solder to change in quality or harden. In this case, the worker divides multiple component mounting positions of second board K2 into multiple work groups. Then, the worker repeats the printing or application of the cream solder for each work group, the carry-in and positioning of second board K2, the mounting work for each work group, and the carry-out of second board K2 to proceed with the manual mounting. Step S8 or step S9 is a step of mounting the components accommodated in carrier member 7 on second board K2, and corresponds to a second work step of the component mounting method of the embodiment.

After step S8 or step S9 is completed, the operation flow merges in step S10. In step S10, when the production quantity of second board K2 is one, the production of second board K2 is completed. When the production quantity of second board K2 is two or more, control device 5 operates board conveyance device 2 to carry second board K2, for which the mounting work has been completed, out of component mounter 1. Next, control device 5 operates board conveyance device 2 to carry next second board K2 into component mounter 1, and repeats step S6 and subsequent steps.

In addition, when a component-out occurs in any of the component containers on carrier member 7 during the mounting work, tray feeder 8 discharges carrier member 7 to tray discharge section 812. The worker takes out carrier member 7 from tray discharge section 812, exchanges the component container that has run out of component with another component container (corresponding to step S24), and then carries carrier member 7 into tray carry-in section 811 again. Further, the worker and control device 5 execute step S25 and subsequent steps to continue the mounting work. As described above, component mounter 1 sequentially carries in multiple second boards K2 to perform the mounting work, and produces multiple second boards K2 by discharging and re-carrying in carrier member 7 in which a component-out has occurred and replenishing components.

In step S11 after the production of second board K2 is completed, mode switching section 55 switches to the first work mode. As necessary to adapt to production of first board K1, the worker performs re-setup of work program 54 for first board K1, readjustment of the separation distance between pair of guide rails 21, and re-exchange of suction nozzle 45 (reverse work of steps S21 to S23). Here, the worker does not need to perform the changeover of multiple tape feeders 32 and pallets 84 that require a large number of man-hours. Thereafter, the operation flow returns to step S2, and control device 5 resumes the production of first board K1. Even when the production of second board K2 is not an interrupt and is incorporated into the production of first board K1 in production plan 62, the same changeover as described above is performed.

In component mounter 1 of the first embodiment, with respect to the component supply, it is possible to perform changeover work of disposing, inside component mounter 1, carrier member 7 on which the strip-shaped carrier tapes (CT11, CT12, and CT13) and tray TR11 are placed. With this, it is possible to perform changeover work targeting carrier member 7 capable of supplying components, instead of the related-art changeover work targeting a reel around which a long second carrier tape is wound, tape feeder 32 that supplies components using the reel, pallet 84 on which the second trays (TR21 and TR22) are placed, and the like. That is, in the related-art technology, a changeover of three tape feeders 32 and one pallet 84 corresponding to four types of components supplied by carrier member 7 is required, but in the first embodiment, it needs only to change over one carrier member 7. Therefore, according to the first embodiment, it is possible to make the changeover more efficient than in a related-art case.

Further, since the components to be mounted on second board K2 are supplied using carrier member 7, when producing second board K2, a changeover that disrupts the arrangement of tape feeders 32 of component supply device 3 is unnecessary, and a changeover that disrupts the arrangement of multiple pallets 84 can be minimized. Further, it is possible to reduce the required man-hours when resuming production of first board K1 and to advance the resumption timing. In addition, by placing multiple component containers (carrier tapes (CT11, CT12, and CT13), and tray TR11) on carrier member 7, it is possible to supply a wide variety of types of components exceeding the number of tape feeders 32 or pallets 84 arranged. In addition, the cut carrier tapes (CT11, CT12, and CT13) can be easily set up and used. In addition, the quantity of components to be supplied may be one or more, and a large number of components may be supplied when some labor of the worker is allowed.

### 7. Modification of First Embodiment

Next, a modification of the first embodiment will be described. In the modification, board conveyance device 2 conveys first board K1 and positions first board K1 at the work position in both the first work mode and the second work mode. In the first work mode, components other than those supplied from carrier member 7 are mounted on first board K1 to form a first board product. In the second work mode, components supplied from carrier member 7 are mounted on first board K1 to form a second board product different in type from the first board product.

Specifically, carrier member 7 is not used in the first work mode. Board conveyance device 2 conveys first board K1 and positions first board K1 at the work position. Component transfer device 4 performs mounting work of picking up a component from at least one of tape feeder 32 and the second trays (TR21 and TR22) on pallet 84 and mounting the picked-up component on positioned first board K1. Naturally, component transfer device 4 does not pick up a component from a component container on carrier member 7 that has not been set up.

In the second work mode, carrier member 7 is set up as illustrated in Fig. 4 and stored in tray stocker 82. Board conveyance device 2 conveys first board K1 and positions first board K1 at the work position. Component transfer device 4 performs mounting work of picking up a component from the component container on carrier member 7 pulled out to the component supply position and mounting the picked-up component on first board K1. Component transfer device 4 may also perform mounting work of picking up a component from at least one of tape feeder 32 and the second trays (TR21 and TR22) and mounting the component on first board K1. In the second work mode, similarly to the first embodiment, control device 5 acquires the accurate position of the component container on carrier member 7 using mark camera 46.

In this type of first board product and second board product, different types of components are mounted at specific component mounting positions on first board K1. For example, a first chip component of 1 kΩ is mounted at a specific component mounting position of first board K1 to form a first board product, and a second chip component having the same shape as the first chip component and a resistance value of 2 kΩ is mounted at a specific component mounting position of first board K1 to form a second board product. The first board product and the second board product are made different in a configuration of an electric circuit, to become different products from each other.

The production start time of the second board product is not particularly limited. That is, the production of the second board product may be planned in production plan 62, or may be started by an interrupt request during the production of the first board product. Further, the production quantity of the first board product and the second board product is not limited. In any case, when the production target is changed from the first board product to the second board product, mode switching section 55 switches from the first work mode to the second work mode.

In the modification, by using carrier member 7, when switching the production target between the first board product and the second board product, the changeover of tape feeder 32 of component supply device 3 is unnecessary, and the changeover of pallet 84 can be minimized. That is, it is possible to reduce the changeover work related to component supply device 3, and it is possible to efficiently perform the changeover accordingly.

### 8. Component Mounter 1A of Second Embodiment

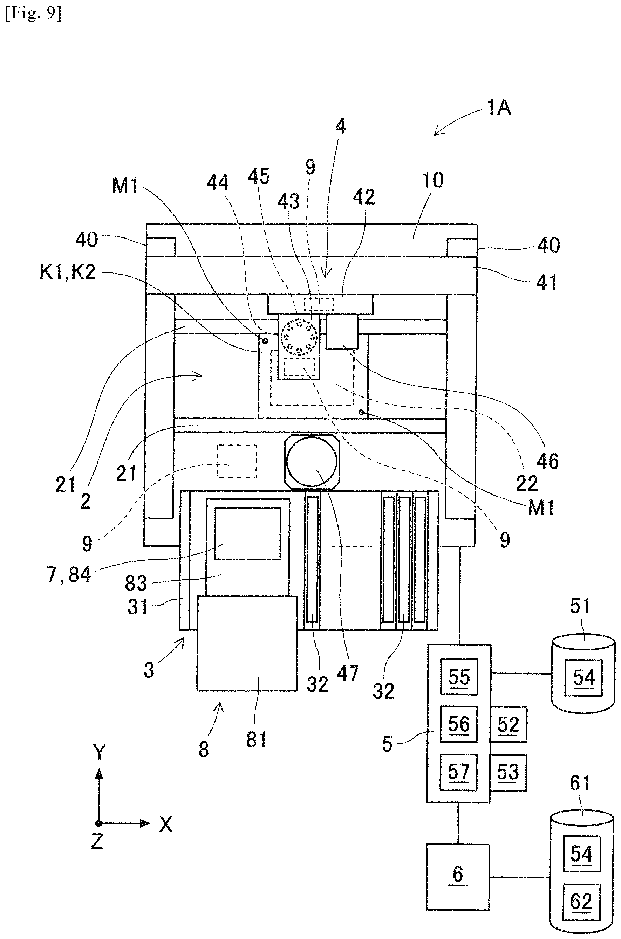

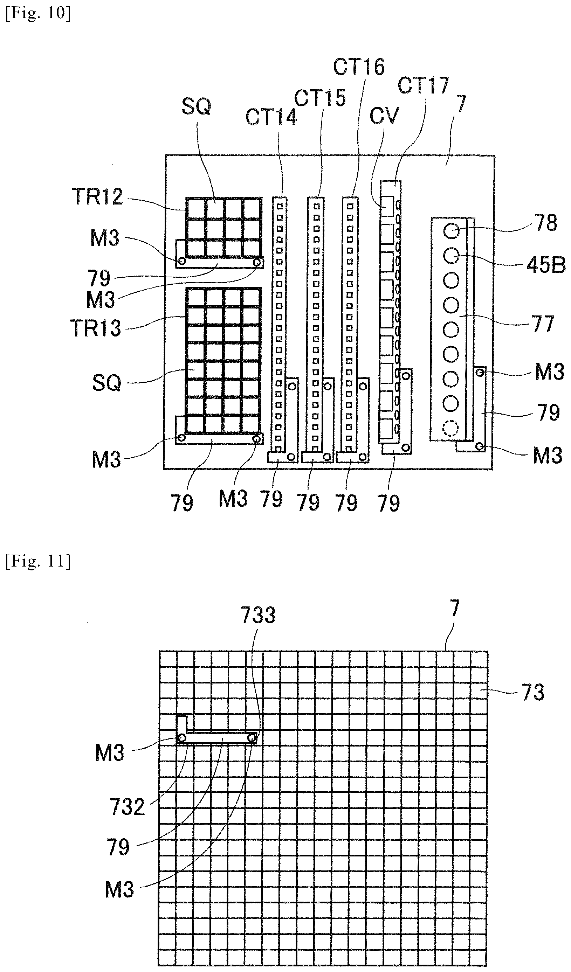

Next, component mounter 1A of a second embodiment will be described with reference to Figs. 9 to 11 mainly on points different from the first embodiment. The overall configuration of component mounter 1A of the second embodiment illustrated in Fig. 9 is different from that of the first embodiment in that bonding material application section 9 is added. In addition, in the second embodiment, similarly to the first embodiment, components to be mounted on second board K2 are supplied using carrier member 7. Note that, as illustrated in Fig. 10, the second embodiment is different from the first embodiment in that tool station 77 and positioning jig 79 are used on carrier member 7.

In the example of Fig. 10, four carrier tapes (CT14, CT15, CT16, and CT17), two trays (TR12 and TR13), and tool station 77 are placed on carrier member 7. Tool station 77 is formed in, for example, an elongated rectangular parallelepiped shape, and has multiple holding holes 78 on an upper surface thereof. Tool station 77 holds suction nozzle 45B in an automatically exchangeable manner in each of multiple holding holes 78.

Suction nozzle 45B is a form of a second component mounting tool that is different in type from the first component mounting tool and that picks up a component from carrier member 7. Suction nozzle 45B picks up a component that is difficult to be picked up by suction nozzle 45 (first component mounting tool) and mounts the component on second board K2. For example, when suction nozzle 45 picks up a relatively large component accommodated in carrier tape CT17 or the trays (TR12 and TR13), a suction error is likely to occur, and suction nozzle 45 cannot be substantially used. To the contrary, since suction nozzle 45B has a tip opening larger than suction nozzle 45, it is possible to stably pick up a relatively large component.

In the second embodiment, the operation flow of Fig. 7 and the sub-operation flow of Fig. 8 are partially changed. That is, step S23 after switching to the second work mode is omitted, and the exchange of suction nozzle 45 by the worker is omitted. Instead, a step of "automatic nozzle exchange" is added before step S27 or after step S28. In the step of the "automatic nozzle exchange", component transfer device 4 moves mounting head 43 to above tool station 77 and automatically exchanges suction nozzle 45 with suction nozzle 45B. In addition, when switching to the first work mode in step S11, instead of the worker having to replace suction nozzle 45 again, component transfer device 4 automatically exchanges suction nozzle 45B with suction nozzle 45. According to this, as compared with the first embodiment, the required man-hours of the changeover work related to component transfer device 4 are reduced.

The number of holding holes 78 of tool station 77 is preferably larger than the maximum number of the suction nozzles (45 and 45B) that can be held by nozzle tool 44. For example, in a configuration in which nozzle tool 44 holds a maximum of eight suction nozzles (45 and 45B), it is preferable to provide nine or more holding holes 78. According to this, the maximum number of suction nozzles 45 held by nozzle tool 44 can be exchanged with suction nozzles 45B. The number of suction nozzles (45 and 45B) to be actually exchanged can be changed within a range from one to the maximum number. Tool station 77 may hold a second component mounting tool other than suction nozzle 45B, for example, a clamping chuck in an automatically exchangeable manner and provide the second component mounting tool to mounting head 43.

Positioning jig 79 is a jig for positioning the component containers (carrier tapes (CT14, CT15, CT16, and CT17), trays (TR12 and TR13)), and tool station 77. In Fig. 10, one positioning jig 79 is used for each of the component containers. In addition, one positioning jig 79 is used in tool station 77. Positioning jig 79 may be used only for a part of the component container.

Positioning jig 79 is formed in an L-shape in which a long arm portion and a short arm portion are orthogonal to each other. Positioning jig 79 is formed of a magnet. Carrier member 7 is formed of a ferromagnetic material such as iron or an alloy containing iron. Therefore, positioning jig 79 is attracted to carrier member 7 by the action of the magnetic force, and is fixed in position so as not to move easily.

Positioning jig 79 has jig position marks M3 at two separate locations. First jig position mark M3 is disposed at an intersection of the long arm portion and the short arm portion. Second jig position mark M3 is disposed at the tip of the long arm portion. Positioning jig 79 performs positioning in contact with two adjacent sides of the component container and tool station 77, which have a rectangular shape in plan view.

As illustrated in Fig. 11, the upper surface of carrier member 7 is divided into a total of 380 elements 73 in which 19 elements 73 are arranged in the left-right direction in the drawing and 20 elements 73 are arranged in the up-down direction in the drawing. An approximate position of positioning jig 79 is indicated by carrier-internal position information represented by element 73 at which jig position mark M3 is located. In the example illustrated in Fig. 11, an approximate position of positioning jig 79 that positions tray TR12 is indicated by carrier-internal position information representing element 732 in the sixth row from the top and the second column from the left and element 733 in the sixth row from the top and the sixth column from the left, which represent a position of jig position mark M3.

The worker disposes positioning jig 79 to be in contact with two sides of one corner of the component container and tool station 77 that have been placed. Alternatively, the worker places the component container and tool station 77 such that two sides thereof are in contact with positioning jig 79 that has been disposed. At this time, since positioning jig 79 is attracted to carrier member 7 by the action of the magnetic force, the positioning work by the worker is facilitated. After the positioning work, the worker uses input device 52 to input information on the element (73, 732, and 733) corresponding to the carrier-internal position information of each of multiple jig position marks M3.

In the second embodiment, steps S27 and S28 in Fig. 8 are changed as follows. That is, mark camera 46 performs a two-stage detection operation when detecting the position of the component on carrier member 7 pulled out to the component supply position. In a first detection operation, mark camera 46 captures an image of jig position mark M3 based on the carrier-internal position information commanded from camera position command section 56. Next, the image processing section of mark camera 46 detects the accurate position of positioning jig 79 and its rotation angle in the horizontal plane by performing image processing on the acquired image data. Further, mark camera 46 can perform an estimation process of estimating the position of the component container and its rotation angle in the horizontal plane based on the known size and shape of positioning jig 79.

In a second detection operation, mark camera 46 refers to the result of the estimation process and the shape information of the component container, and captures an image of the specific position of the component container or the specific component. Next, the image processing section of mark camera 46 detects the accurate position of the specific component by performing image processing on the acquired image data. Further, mark camera 46 obtains accurate positions of all components in the component container by referring to the shape information of the component container. By the two-stage detection operation, the position of the component accommodated in the component container can be detected more reliably than in the first embodiment. Even though the positioning work by the worker is inaccurate and there is a gap between the component container and positioning jig 79, the second detection operation ensures highly accurate position detection.

The first detection operation and the second detection operation are performed on tool station 77, and the accurate positions of multiple suction nozzles 45B are obtained and reflected in the automatic exchange. A simplified method may also be adopted in which the first detection operation and the estimation process are performed while omitting the second detection operation. In addition, positioning jigs 79 may be positioned in a pair at two corners on a diagonal line of the component container and tool station 77. In this embodiment, the number of positioning jigs 79 used is doubled, but the position and the rotation angle can be detected more accurately. In addition, in the trays (TR12 and TR13) and tool station 77, pair of positioning jigs 79 eliminate the risk of sideslip during conveyance, and thus it is possible to omit the attachment with the double-sided tape.

As illustrated by a broken line in Fig. 9, bonding material application section 9 is provided at one or more locations of mounting head 43, X-axis moving body 42, and base 10. Bonding material application section 9 applies a bonding material for electrical connection to a predetermined component mounting position of the positioned board. Alternatively, bonding material application section 9 applies a bonding material to electrodes of the components mounted on the board. The bonding material is not limited to cream solder, and may also be, for example, a conductive ink that dries to form a conductive portion. Bonding material application section 9 may be originally provided.

Bonding material application section 9 can be exemplified by an inkjet nozzle device, but is not limited to this. The inkjet nozzle device includes a nozzle disposed on mounting head 43 or X-axis moving body 42, and a maintenance section disposed on base 10. The nozzle is driven by component transfer device 4 to move in the horizontal direction with an ejection port or a dropping port facing downward. The nozzle ejects or drops the conductive ink toward the component mounting position on the board. The maintenance section performs operations such as cleaning a nozzle that has moved to an upper position and replenishing the conductive ink.

Bonding material application section 9 can operate based on work program 54, and can also operate in accordance with a command from the worker. Bonding material application section 9 can operate at any desired timing for a board positioned at the work position or a component picked up from the component supply position. Therefore, it is not necessary to print or apply the cream solder on the board in advance using a solder printer or another device, and the risk of change in quality or hardening of the cream solder is eliminated. In addition, even when second board K2 is a repair board and the solder printer cannot be applied due to the presence of the mounted component, the bonding material can be applied by bonding material application section 9 to handle the situation.

As described above, in the second embodiment, by using tool station 77, the required man-hours of the changeover work related to component transfer device 4 are reduced. In addition, by using positioning jig 79 having two jig position marks M3 attached thereon, the accurate position of the component on carrier member 7 can be detected more reliably than in the first embodiment. Further, by using bonding material application section 9, it is possible to eliminate the risk of change in quality and hardening of the cream solder, and bonding material application section 9 is effective particularly for manual mounting work that requires time, and enables handling of a repair board. In addition, in the related-art technology, a changeover of four tape feeders 32 and at least one pallet 84 corresponding to six types of components supplied by carrier member 7 is required, but in the second embodiment, it needs only to change over one carrier member 7. Therefore, according to the second embodiment, similarly to the first embodiment, it is possible to efficiently perform the changeover when switching the production target between first board K1 and second board K2.

### 9. Applications and Modifications of Embodiment

In the first and second embodiments, by storing multiple carrier members 7 in tray stocker 82 of tray feeder 8, or by alternately storing multiple carrier members 7 in tray stocker 82, the quantity and the number of types of components supplied from carrier members 7 can be increased. In addition, carrier member 7 can be used by means other than tray feeder 8 constituting component supply device 3.

For example, tray feeder 8 may be omitted, and the worker may open protection cover 11 to carry carrier member 7 into the component mounter. In this aspect, the worker disposes carrier member 7 at a position within the movement range of mounting head 43 on the upper surface of mounting base 31 or base 10. In the first work mode, component transfer device 4 picks up the component from tape feeder 32 and performs the mounting work on first board K1 (or the mounting work of the first board product) without picking up the component from carrier member 7. In addition, in the second work mode, component transfer device 4 picks up the component from carrier member 7, picks up the component from tape feeder 32 as necessary, and performs the mounting work on second board K2 (or the mounting work of the second board product).

Tape feeder 32 of component supply device 3 may be omitted. In this aspect, in the first work mode, component transfer device 4 picks up the component from pallet 84 and performs the mounting work on first board K1 (or the mounting work of the first board product) without picking up the component from carrier member 7. In addition, in the second work mode, component transfer device 4 picks up the component from carrier member 7, picks up the component from pallet 84 as necessary, and performs the mounting work on second board K2 (or the mounting work of the second board product).

In addition, in the first and second embodiments, even components that can be supplied from tape feeder 32 and pallet 84 can be placed on carrier member 7 and be supplied. For example, components of the same type as the components supplied from tape feeder 32 and pallet 84 but with different supplementary information such as a lot or a supplier can be placed on carrier member 7 and be supplied. Component transfer device 4 mounts the component picked up from tape feeder 32 or pallet 84 on first board K1 to produce the first board product, and mounts the component picked up from carrier member 7 on first board K1 to produce the second board product. Accordingly, the first board product and the second board product are of the same type in design, and it is possible to verify the influence of the difference in the supplementary information of the component by performing a comparative test.

Further, tool station 77 and positioning jig 79 described in the second embodiment can also be used in the first embodiment. In addition, a member other than the component containers described in the first and second embodiments may be placed on carrier member 7. For example, a component to be fixed to the component mounting position on the board by using an adhesive can be placed on carrier member 7, and bonding material application section 9 described in the second embodiment may be configured to apply the adhesive. Further, the first and second embodiments can be applied and modified in various ways.

### Reference Signs List

1, 1A: Component mounter, 2: Board conveyance device, 3: Component supply device, 32: Tape feeder, 4: Component transfer device, 43: Mounting head, 45, 45B: Suction nozzle, 46: Mark camera, 5: Control device, 53: Display device, 54: Work program, 55: Mode switching section, 56: Camera position command section, 57: Display control section, 6: Production management device, 62: Production plan, 7: Carrier member, 73, 731, 732, 733: Element, 77: Tool station, 79: Positioning jig, 7A: Overall image, 8: Tray feeder, 84: Pallet, 9: Bonding material application section, K1: First board, K2: Second board, M1: Board position mark, M3: Jig position mark, CT11 to CT17: Carrier tape, TR11 to TR13: Tray, TR21, TR22: Second tray, DSP: Screen, AR: Imaging range, FD: Image data

## Claims

1. A component mounter comprising:
a carrier member on which a strip-shaped carrier tape in which components to be mounted on a board are respectively accommodated in multiple cavities arranged in a row and a tray in which the components are respectively accommodated in multiple accommodation portions arranged in a grid pattern are placed, the carrier member being disposed inside the component mounter; and
a component transfer device configured to pick up the component from the carrier member and mount the picked-up component on the board positioned at a work position.

2. The component mounter according to Claim 1, further comprising:
a tray feeder configured to selectively and automatically exchangeably dispose, inside the component mounter, a pallet on which a second tray that accommodates components of a type different from the components accommodated in the tray placed on the carrier member is placed, and the carrier member.

3. The component mounter according to Claim 2, further comprising:
a board conveyance device configured to convey the board and position the board at a predetermined work position; and
a mode switching section configured to switch between a first work mode in which the component transfer device mounts the components accommodated in the second tray on a first board positioned at the work position by the board conveyance device without using the carrier member and a second work mode in which the component transfer device mounts at least the components accommodated in the carrier member on a second board that is positioned at the work position by the board conveyance device and is of a type different from the first board.

4. The component mounter according to Claim 2, further comprising:
a board conveyance device configured to convey the board and position the board at a predetermined work position; and
a mode switching section configured to switch between a first work mode in which the component transfer device mounts the components accommodated in the second tray on the board positioned at the work position by the board conveyance device without using the carrier member and a second work mode in which the component transfer device mounts at least the components accommodated in the carrier member.

5. The component mounter according to Claim 1, further comprising:
a tape feeder configured to supply components of a type different from the components accommodated in the strip-shaped carrier tape placed on the carrier member by using a second carrier tape that accommodates the different components.

6. The component mounter according to Claim 5, further comprising:
a board conveyance device configured to convey the board and position the board at a predetermined work position; and
a mode switching section configured to switch between a first work mode in which the component transfer device mounts the components accommodated in the tape feeder on a first board positioned at the work position by the board conveyance device without using the carrier member and a second work mode in which the component transfer device mounts at least the components accommodated in the carrier member on a second board that is positioned at the work position by the board conveyance device and is of a type different from the first board.

7. The component mounter according to Claim 5, further comprising:
a board conveyance device configured to convey the board and position the board at a predetermined work position; and
a mode switching section configured to switch between a first work mode in which the component transfer device mounts the components accommodated in the tape feeder on the board positioned at the work position by the board conveyance device without using the carrier member and a second work mode in which the component transfer device mounts at least the components accommodated in the carrier member.

8. The component mounter according to Claim 3 or 6,
wherein the first board is a planned production board that is produced based on a production plan,
the second board is an interrupt production board that is produced by interrupting the production plan, and
the mode switching section is configured to set the first work mode in a normal state in which an interrupt request for producing the interrupt production board is not generated, switch to the second work mode when the interrupt request is generated, and switch to the first work mode after production of the interrupt production board is completed.

9. The component mounter according to Claim 4 or 7, wherein the board becomes a first board product when the components accommodated in the carrier member are not mounted in the first work mode, and becomes a second board product different in type from the first board product when at least the components accommodated in the carrier member are mounted in the second work mode.

10. The component mounter according to any one of Claims 3, 4, 6, and 7,
wherein the component transfer device includes a movable mark camera configured to, in the second work mode, capture an image of a predetermined component mounting position or a mounted component on the board positioned at the work position and an image of either the carrier tape or the tray placed on the carrier member and acquire image data, and
the component mounter comprises a display device configured to display image-capturing position information indicating a position or an image-capturing range of the mark camera during image-capturing and the image data on one screen.

11. The component mounter according to Claim 10, wherein the display device is configured to superimpose and display, in a graphical form, the image-capturing position information on an overall image of any one of the carrier member, the carrier tape, and the tray, the overall image being acquired from outside the component mounter.

12. The component mounter according to Claim 10,
wherein the second work mode includes
a setup mode in which a worker sets up a work program for the component transfer device to automatically perform mounting work by referring to the display of the display device, and
an automatic mounting mode in which the component transfer device automatically performs the mounting work based on the work program.

13. The component mounter according to Claim 10, wherein the second work mode includes a manual mounting mode in which a worker manually performs mounting work while referring to the display of the display device.

14. The component mounter according to Claim 1,
wherein the component transfer device includes a movable mark camera configured to capture an image of the carrier tape or the tray placed on the carrier member and detect a position of the carrier tape or the tray, and
the component mounter comprises a camera position command section configured to use carrier-internal position information that is obtained by dividing at least one of an upper surface of the board positioned at the work position and an upper surface of the carrier member disposed inside the component mounter into multiple elements arranged in a grid pattern and that represents, with any of the elements, an approximate position of at least one of a board position mark attached to the board, a component mounting position defined on the board, the carrier tape, and the tray, to issue a command for a position of the mark camera when capturing an image of at least one of the board position mark, the component mounting position, the carrier tape, and the tray.

15. The component mounter according to Claim 1,
wherein the carrier member includes a positioning jig configured to position the carrier tape or the tray and having a jig position mark attached thereon, and
the component transfer device includes a movable mark camera configured to capture an image of the jig position mark attached to the positioning jig included in the positioned carrier member, detect a position of the positioning jig, and estimate a position of the carrier tape or the tray.

16. The component mounter according to Claim 15,
wherein the positioning jig is formed in an L-shape in contact with two sides of the carrier tape or the tray having a rectangular shape in plan view, and has multiple jig position marks attached thereon, and
the mark camera is configured to capture images of the multiple jig position marks, detect the position of the positioning jig and a rotation angle thereof in a horizontal plane, and estimate the position of the carrier tape or the tray and a rotation angle thereof in a horizontal plane.

17. The component mounter according to Claim 15, further comprising:
a camera position command section configured to use carrier-internal position information that is obtained by dividing an upper surface of the carrier member into multiple elements arranged in a grid pattern and that represents, with any of the elements, an approximate position of the jig position mark, to issue a command for a position of the mark camera when capturing an image of the jig position mark.

18. The component mounter according to Claim 14 or 17, wherein each of the multiple elements has the same shape and the same size as an image-capturing range of the mark camera or is smaller than the image-capturing range.

19. The component mounter according to Claim 14 or 17,
wherein each of the multiple elements is larger than an image-capturing range of the mark camera, and
the camera position command section is configured to issue a command for the mark camera to perform imaging at multiple positions in the element.

20. The component mounter according to Claim 15,
wherein the carrier member is ferromagnetic, and
the positioning jig is formed so as to be attracted to the carrier member using a magnet.

21. The component mounter according to Claim 3 or 4,
wherein the component transfer device includes a first component mounting tool configured to pick up the component from the second tray, and a mounting head configured to move while exchangeably holding the first component mounting tool,
a second component mounting tool different in type from the first component mounting tool and configured to pick up the component from the carrier member is placed on the carrier member, and
the component transfer device is configured to exchange the first component mounting tool held by the mounting head with the second component mounting tool placed on the carrier member in the second work mode.

22. The component mounter according to Claim 6 or 7,
wherein the component transfer device includes a first component mounting tool configured to pick up the component from the tape feeder, and a mounting head configured to move while exchangeably holding the first component mounting tool,
a second component mounting tool different in type from the first component mounting tool and configured to pick up the component from the carrier member is placed on the carrier member, and
the component transfer device is configured to exchange the first component mounting tool held by the mounting head with the second component mounting tool placed on the carrier member in the second work mode.

23. The component mounter according to any one of Claims 1 to 7, further comprising:
a bonding material application section configured to apply a bonding material for electrical connection to a predetermined component mounting position on the positioned board, or to electrodes of the components accommodated in the carrier tape or the tray placed on the carrier member.

24. A component mounting method using a component mounter including a tray feeder, a board conveyance device, and a component transfer device, the component mounting method comprising:
a setup step of disposing, on the tray feeder, a carrier member on which a strip-shaped carrier tape in which components to be mounted on a board are respectively accommodated in multiple cavities arranged in a row and a tray in which the components are respectively accommodated in multiple accommodation portions arranged in a grid pattern are placed;
a first work step of, via the component transfer device, mounting, on a first board positioned at a predetermined work position by the board conveyance device, components accommodated in a second tray that accommodates components of a type different from the components accommodated in the tray without using the carrier member; and
a second work step of, via the component transfer device, mounting, on a second board positioned at a predetermined work position by the board conveyance device, the components accommodated in the carrier member.

25. A component mounting method using a component mounter including a tape feeder, a board conveyance device, and a component transfer device, the component mounting method comprising:
a setup step of disposing, on the component mounter, a carrier member on which a strip-shaped carrier tape in which components to be mounted on a board are respectively accommodated in multiple cavities arranged in a row and a tray in which the components are respectively accommodated in multiple accommodation portions arranged in a grid pattern are placed;
a first work step of, via the component transfer device, mounting, on a first board positioned at a predetermined work position by the board conveyance device, components accommodated in a second carrier tape attached to the tape feeder without using the carrier member; and
a second work step of, via the component transfer device, mounting, on a second board positioned at a predetermined work position by the board conveyance device, the components accommodated in the carrier member.
